# EUROPEAN PATENT APPLICATION

(11) **EP 4 693 419 A1**
(43) Date of publication of application: **11.02.2026**
(21) Application number: 24783951.7
(22) Date of filing: 18.01.2024
(51) Int. Cl.: H01L 33/54, H01L 33/58

(54) **LIGHT-EMITTING DEVICE AND DISPLAY MODULE**

(30) Priority: 06.04.2023 CN 202320754512 U
(71) Applicant: Huizhou Vision New Technology Co., Ltd., Huizhou, Guangdong 516000 (CN)
(72) Inventor: GAO, Wei, Huizhou, Guangdong 516000 (CN)
(74) Representative: Herrero & Asociados, S.L.
(86) International application number: PCT/CN2024/072946
(87) International publication number: WO 2024/207866

(57) **Abstract**

Provided in the embodiments of the present disclosure is a light-emitting device including a device support, a silicone lens and at least one LED chip. The device support and the silicone lens are bonded and enclose to form a packaging cavity. The LED chip is located in the packaging cavity. The light-emitting device may reduce the number of light-emitting devices used in a backlight source, thereby reducing the cost of display product.

## Description

This present application claims priority of the Chinese patent application with the Chinese Patent Application No. 202320754512.1, filed in the China National Intellectual Property Administration on April 6, 2023, and entitled "LIGHT-EMITTING DEVICE AND DISPLAY MODULE", which is incorporated herein by reference in its entirety.

### TECHNICAL FIELD

The present disclosure relates to a field of optoelectronic display technology, and in particular to a light-emitting device and a display module.

### BACKGROUND

In recent years, Mini LED display technology has developed rapidly, and Mini LED display products are increasingly widely used. In the related art, Mini LED is often packaged by POB (package on board) to form a Mini LED POB lamp bead.

### TECHNICAL PROBLEM

When a Mini LED display product uses a Mini LED POB lamp bead to form a backlight source, a large number of Mini LED POB lamp beads need to be used, resulting in a significant increase in product cost.

### TECHNICAL SOLUTION

The embodiments of the present disclosure provide a light-emitting device and a display module, which may reduce the number of light-emitting devices used in the backlight source, thereby reducing the cost of the display product.

In one aspect, the embodiments of the present disclosure provide a light-emitting device including a device support, a silicone lens, and at least one LED chip; the device support and the silicone lens are bonded and enclosed to form a packaging cavity, and the at least one LED chip is located in the packaging cavity.

In some embodiments, the device support is provided with a mounting groove with an opening facing the silicone lens, the at least one LED chip is embedded in the mounting groove, and an orthographic projection of the silicone lens on the device support covers the mounting groove.

In some embodiments, a cross-sectional area of the mounting groove increases along a direction approaching the silicone lens.

In some embodiments, the device support includes a surface reflection layer, and the surface reflection layer is formed at least on a surface region of the mounting groove; or the device support is a high-reflectivity metal support.

In some embodiments, the light-emitting device further includes a fluorescent conversion layer, and the fluorescent conversion layer is filled in the packaging cavity.

In some embodiments, the silicone lens includes an outer surface and an inner surface arranged in opposite to each other along a thickness direction of the silicone lens, the inner surface faces the device support and the at least one LED chip, and the inner surface is spaced apart from the at least one LED chip.

In some embodiments, the silicone lens has a truncated-pyramid shape, the truncated-pyramid shape includes an upper bottom surface, a lower bottom surface and a peripheral surface connecting the upper bottom surface and the lower bottom surface, the upper bottom surface and the lower bottom surface are arranged in parallel and opposite to each other, and the lower bottom surface is connected to the device support; the upper bottom surface is a circular plane or an elliptical plane, the peripheral surface is an arc-curved surface, and a light pattern of the silicone lens is circular or elliptical.

In some embodiments, the device support is at least partially conductive, and the at least one LED chip is conductively connected to a conductive part of the device support.

In another aspect, the embodiments of the present disclosure provide a display module including a back plate and a light-emitting device provided in any of the above embodiments, and the light-emitting device is disposed on the back plate.

In some embodiments, the display module includes a printed circuit board, the printed circuit board is disposed on the back plate, and a plurality of the light-emitting devices are arranged in an array on a side surface of the printed circuit board away from the back plate and spaced apart from each other.

### BENEFICIAL EFFECTS

The light-emitting device and the display module provided by the embodiments of the present disclosure are provided with a device support, an LED chip, and a silicone lens. The silicone lens is bonded and fixed on the device support after being pre-injection molded. The at least one LED chip is reliably packaged by using the silicone lens. The shape of the silicone lens based on the injection molding structure may be accurately controlled in a preset mode, so that the light pattern controllability and consistency of the light-emitting device are high. The side surfaces of the silicone lens are easy to be secondarily optically designed and constructed, so that the light-emitting angle of the light-emitting device may be further increased. Compared with the related art, the light-emitting device provided by the embodiments of the present disclosure has high light pattern consistency and a large light-emitting angle. When the light-emitting device is used to manufacture a backlight source, a small number of light-emitting devices are used to meet the light-emitting display requirements of the backlight source. The allowable spacing between the light-emitting devices is effectively increased, and the number of the light-emitting devices used is correspondingly reduced, so that the cost of the display product is reduced.

### BRIEF DESCRIPTION OF DRAWINGS

In order to more clearly illustrate the technical solutions in the embodiments of the present disclosure, the following briefly describes the drawings needed in the embodiment description. Obviously, the drawings in the following description merely show some of the embodiments of the present disclosure, and other drawings may be obtained by those skilled in the art without creative effort.
FIG. 1 is a sectional structure diagram of a light-emitting device according to some embodiments of the present disclosure;
FIG. 2 is a perspective sectional structure diagram of a light-emitting device according to some embodiments of the present disclosure;
FIG. 3 is another sectional structure diagram of a light-emitting device according to some embodiments of the present disclosure;
FIG. 4 is a partial structure diagram of a display module according to some embodiments of the present disclosure;
FIG. 5 is another partial structure diagram of a display module according to some embodiments of the present disclosure.

Explanation of main element symbols:
100, display module; 1, light-emitting device; 10, device support; 11, mounting groove; 12, surface reflection layer; 20, LED chip; 30, silicone lens; 31, upper bottom surface; 32, lower bottom surface; 33, peripheral surface; 40, fluorescent conversion layer; 2, back plate; 3, printed circuit board; 4, diffusion plate support; 5, diffusion plate; 6, optical film; 7, display panel; 8, reflective sheet.

### EMBODIMENTS OF THE PRESENT DISCLOSURE

The technical solutions in the present disclosure will be described clearly and completely below in combination with the drawings in the embodiments of the present disclosure. Obviously, the described embodiments are only part of the embodiments of the present disclosure, rather than all the embodiments. Based on the embodiments in the present disclosure, all the other embodiments obtained by those skilled in the art without creative work are within the protection scope of the present disclosure.

In the description of the disclosure, it needs to be understood that the orientation or positional relationship indicated by the terms "center", "longitudinal", "transverse", "length", "width", "thickness", "upper", "lower", "front", "back", "left", "right", "vertical", "horizontal", "top", "bottom", "inner", "outer" and the like is based on the orientation or positional relationship shown in the drawings, and is only for the convenience of describing the disclosure and simplifying the description, and does not indicate or imply that the device or element referred to must have a particular orientation, be constructed and operated in a particular orientation, and therefore maynot be understood as a limitation on the disclosure. In addition, the terms "first" and "second" are only used for descriptive purposes, and maynot be understood as indicating or implying relative importance or implicitly indicating the number of the technical features indicated. Therefore, the features defined with "first" and "second" may explicitly or implicitly include one or more of the features. In the description of the disclosure, "a plurality of" means two or more, unless otherwise specifically and definitely defined.

"A and/or B" includes the following three combinations: only A, only B, and a combination of A and B.

The use of "adapted to" or "configured to" in the present disclosure means open and inclusive language that does not exclude additional devices that are adapted to or configured to perform additional tasks or steps. Additionally, the use of "based on" means open and inclusive, as a process, step, calculation, or other action that is "based on" one or more recited conditions or values may in practice be based on additional conditions or values beyond those recited.

In the present disclosure, the word "exemplary" is used to mean "serving as an example, instance, or illustration." Any embodiment described as "exemplary" in the present disclosure is not necessarily to be construed as preferred or advantageous over other embodiments. The following description is presented to enable those skilled in the art to make and use the disclosure. Details are set forth in the following description for purpose of explanation. It should be appreciated that one of ordinary skill in the art would realize that the disclosure may be practiced without the use of these specific details. In other instances, well known structures and processes are not elaborated in order not to obscure the description of the disclosure with unnecessary details. Thus, the present disclosure is not intended to be limited by the embodiments shown, but is to be accorded with the widest scope consistent with the principles and features disclosed herein.

In the related art, the Mini LED POB lamp bead mainly adopts a dispensing mode to package the Mini LED chip. Due to the constraint of the process technology, the dispensing mode is limited in increasing the light-emitting angle of the Mini LED POB lamp bead, resulting in a small light-emitting angle of the Mini LED POB lamp bead. In addition, the dispensing mode maynot accurately control the shape, resulting in poor controllability and consistency of the light pattern, and the light-emitting light pattern defect is prone to occur. When the Mini LED POB lamp bead is used to manufacture a backlight source, in order to meet the light-emitting display needs of the backlight source, a large number of Mini LED POB lamp beads are required to form a relatively dense light-emitting array. Due to the large number of lamp beads, the cost of the Mini LED display product manufactured thereby is significantly increased.

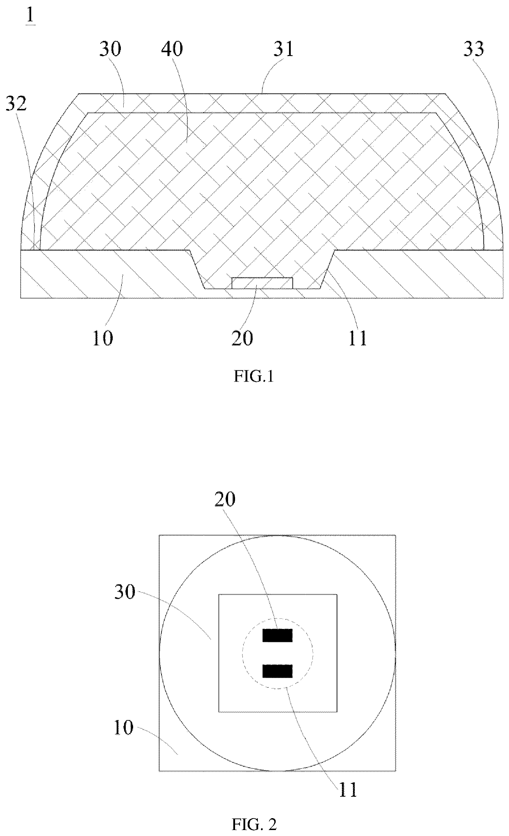

As shown in FIG 1 to FIG 2, in one aspect, the embodiment of the present disclosure provides a light-emitting device 1. The light-emitting device 1 includes a device support 10, at least one LED chip 20, and a silicone lens 30. The use amount of the light-emitting device 1 in a backlight source may be reduced, thereby reducing the cost of the display product.

A type of the at least one LED chip 20 may be determined according to actual needs, and may be, for example, a Mini LED chip 20, which may be excited to emit light when energized, and the embodiment of the present disclosure is not limited in this regard. The number of the at least one LED chips 20 may be determined according to actual needs, and may be one or more, to match the required light-emitting power and brightness needs.

The silicone lens 30 may be pre-fabricated by an injection molding process, and then bonded and fixed on the device support 10, and the enclosure device support 10 and the silicone lens 30 enclose to form a packaging cavity. An orthographic projection of the silicone lens 30 on the device support 10 covers a mounting groove 11, so that the mounting groove 11 is located in the packaging cavity as a whole; accordingly, the at least one LED chip 20 is reliably packaged in the packaging cavity. Since the silicone lens 30 is pre-injection molded, on the one hand, the shape of the silicone lens 30 may be accurately controlled in a preset shape, so that the light pattern controllability and consistency of the light-emitting device 1 are high; on the other hand, each side surface of the silicone lens 30 is easy to be secondarily optically designed and constructed, so that refraction and reflection effects may occur on the surface of the silicone lens 30, and further increasing the light-emitting angle of the light-emitting device 1.

In this way, compared with the related art, the light-emitting device 1 provided by the embodiment of the present disclosure has a high light pattern consistency and a large light-emitting angle. When the light-emitting device 1 is used to manufacture a backlight source, only a small number of light-emitting devices 1 are required to meet the light-emitting display needs of the backlight source, the allowable spacing between the light-emitting devices 1 is effectively increased, the use amount of the light-emitting devices 1 is correspondingly reduced, and thus the cost of the display product is reduced.

In some embodiments, the device support 10 may be provided with a mounting groove 11, which may be recessed formed on a side surface of the device support 10 and includes an opening facing the silicone lens 30. The at least one LED chip 20 is embedded in the mounting groove 11 to form a relatively compact mounting structure, so that the at least one LED chip 20 is reliably protected by the device support 10.

An extension structure of the mounting groove 11 may be determined according to actual needs, and the embodiments of the present disclosure do not make a limitation in this regard. In some embodiments, a cross-sectional area of the mounting groove 11 may increase along a direction approaching the silicone lens 30. The cross-sectional area of one end of the mounting groove 11 close to the silicone lens 30 is relatively large, so that the light passing area of this end is relatively large, while the cross-sectional area of another end of the mounting groove 11 away from the silicone lens 30 is relatively small, so as to form a compact mounting structure with the at least one LED chip 20. In this way, the light emitted by the at least one LED chip 20 may gradually spread along with the increase of the light passing area in the mounting groove 11, the light emitting area of the at least one LED chip 20 through the mounting groove 11 may be increased, and then the light emitting angle of the light-emitting device 1 may be increased.

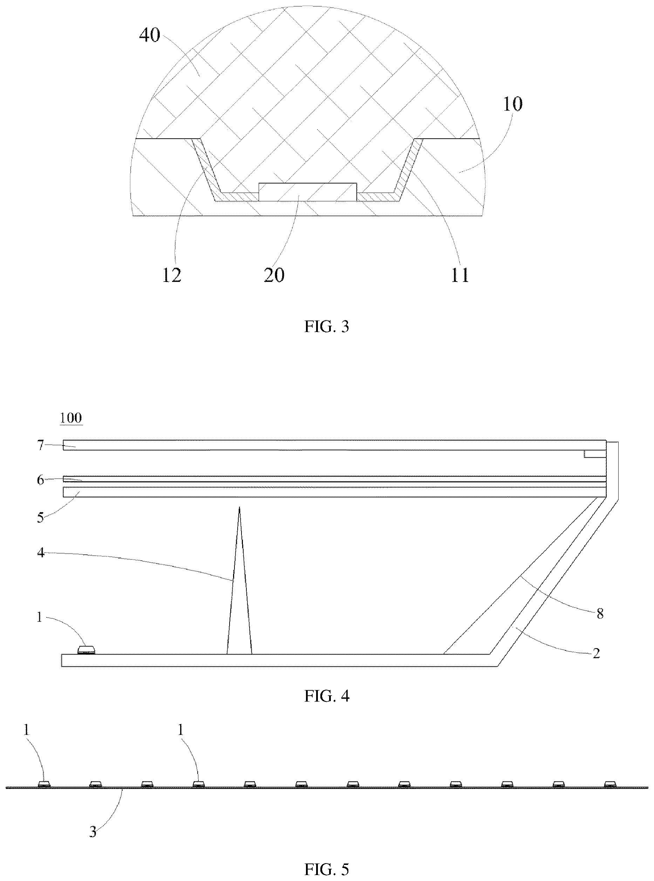

As shown in FIG. 3, in some embodiments, the device support 10 may include a surface reflection layer 12. The surface reflection layer 12 is formed at least on a surface region of the mounting groove 11. In this way, when the light emitted by the at least one LED chip 20 irradiates on the surface of the mounting groove 11, the surface reflection layer 12 on the surface of the mounting groove 11 may reflect the light, so that the light is emitted out of the mounting groove 11 after one or more times of reflection, thereby increasing the light emitting quantity and the light utilization rate of the light-emitting device 1. A material of the surface reflection layer 12 may be determined according to actual needs, and may be made of, for example, high reflectivity metal, white coating and the like, and the embodiments of the present disclosure do not make a limitation in this regard.

In other embodiments, the device support 10 may be a high reflectivity metal support. The high reflectivity metal support is integrally made of a high emissivity metal material, such as copper, aluminum and the like. The high reflectivity metal has a relatively high reflectivity to the light emitted by the at least one LED chip 20. When the light emitted by the at least one LED chip 20 irradiates on the surface of the device support 10, the surface of the device support 10 may reflect the light, so that the light is emitted out of the device support 10 after one or more times of reflection, thereby increasing the light emitting quantity and the light utilization rate of the light-emitting device 1.

As shown in FIG. 1, in some embodiments, the light-emitting device 1 may include a fluorescent conversion layer 40. The fluorescent conversion layer 40 is filled in the packaging cavity. The fluorescent conversion layer 40 is formed by a fluorescent powder filled in the packaging cavity. The fluorescent conversion layer 40 may perform color conversion on the light emitted by the at least one LED chip 20, so that the light-emitting device 1 may achieve the required light emitting color. The color of the fluorescent powder in the fluorescent conversion layer 40 may be determined according to actual needs, and may be, for example, yellow fluorescent powder, green fluorescent powder and the like, and the embodiments of the present disclosure do not make a limitation in this regard.

The shape and the light pattern of the silicone lens 30 may be determined according to actual requirements, and the embodiments of the present disclosure do not limit the same. In some embodiments, the silicone lens 30 may have a truncated-pyramid shape. The truncated-pyramid shape includes an upper bottom surface 31, a lower bottom surface 32, and a peripheral surface 33 connecting the upper bottom surface 31 and the lower bottom surface 32. The upper bottom surface 31 and the lower bottom surface 32 are arranged in parallel and opposite to each other, and the lower bottom surface 32 is connected to the device support 10. The upper bottom surface 31 is a circular plane or an elliptical plane, and the peripheral surface 33 is an arc-shaped curved surface, thereby the light pattern of the silicone lens 30 is circular or elliptical, which may match the required light emitting requirements.

In some embodiments, the silicone lens 30 includes an outer surface and an inner surface arranged in opposite to each other along the thickness direction thereof. The inner surface faces the device support 10 and the at least one LED chip 20, and the inner surface is spaced apart from the at least one LED chip 20. In this way, the outer surface and the inner surface of the silicone lens 30 may be respectively configured to achieve the secondary optical design purpose, and the refraction/reflection effect of the outer surface and the inner surface of the silicone lens 30 on the light may further increase the light emitting angle of the silicone lens 30, thereby increasing the light emitting angle of the light-emitting device 1.

In some embodiments, the device support 10 may be at least partially conductive, and the at least one LED chip 20 and a conductive part of the device support 10 are conductively connected. In this way, the at least one LED chip 20 may be conductively driven by the device support 10, and the circuit connection structure is simplified and the function of the device support 10 is increased.

As shown in FIG. 1 to FIG. 4, in another aspect, the embodiments of the present disclosure provide a display module 100. The display module 100 includes a back plate 2 and the light-emitting device 1 provided by any of the above embodiments. The light-emitting device 1 is disposed on the back plate 2. The type of the display module 100 may be determined according to actual requirements, such as a direct type display module, a side-in type display module and the like, and the embodiments of the present disclosure do not limit the same. The use of the display module 100 may be determined according to actual requirements, and the display module 100 may be used as a whole machine product with a display function or a display component therein, the whole machine product may include a television, a display and a smart terminal, and the embodiments of the present disclosure do not limit the same.

As shown in FIG. 5, in some embodiments, the display module 100 may include a printed circuit board 3. The printed circuit board 3 is disposed on the back plate 2, and a plurality of light-emitting devices 1 are arranged at intervals on a side surface of the printed circuit board 3 away from the back plate 2. In this way, a light bar or a light plate structure may be formed by using the printed circuit board 3 and the plurality of light-emitting devices 1 thereon, and a required light emitting array structure may be achieved.

As shown in FIG. 4, in some embodiments, the display module 100 may further include a diffusion plate support 4, a diffusion plate 5, an optical film 6, a display panel 7, and a reflective sheet 8. The reflective sheet 8 and the diffusion plate support 4 are respectively disposed on a side surface of the back plate 2 facing the display panel 7, the diffusion plate 5 is disposed on a side surface of the diffusion plate support 4 away from the reflective sheet 8, the optical film 6 is disposed on a side of the diffusion plate 5 away from the diffusion plate support 4, and the display panel 7 is disposed on a side of the optical film 6 away from the diffusion plate 5 and fixed on the back plate 2.

The light-emitting device and the display module provided by the embodiments of the present disclosure are described in detail above. The principle and implementation manner of the embodiment of the present disclosure are described by using specific examples. The above description of the embodiments is only used to help understand the technical solution and the core idea of the embodiment of the present disclosure. Those skilled in the art should understand that the technical solution recorded in the above embodiments may still be modified, or part of the technical features may be replaced by equivalent features. The modification or replacement does not make the essence of the corresponding technical solution deviate from the scope of the technical solution of the embodiment of the present disclosure.

## Claims

1. A light-emitting device, comprising:
a device support;
a silicone lens; and
at least one LED chip;
wherein the device support and the silicone lens are bonded and enclosed to form a packaging cavity, and the at least one LED chip is located in the packaging cavity.

2. The light-emitting device of claim 1, wherein the device support is provided with a mounting groove with an opening facing the silicone lens, the at least one LED chip is embedded in the mounting groove, and an orthographic projection of the silicone lens on the device support covers the mounting groove.

3. The light-emitting device of claim 2, wherein a cross-sectional area of the mounting groove increases along a direction approaching the silicone lens.

4. The light-emitting device of claim 2, wherein the device support comprises a surface reflection layer, and the surface reflection layer is formed at least on a surface region of the mounting groove.

5. The light-emitting device of claim 2, wherein the device support is a high-reflectivity metal support.

6. The light-emitting device of claim 1, wherein the light-emitting device further comprises a fluorescent conversion layer, and the fluorescent conversion layer is filled in the packaging cavity.

7. The light-emitting device of claim 1, wherein the silicone lens comprises an outer surface and an inner surface arranged in opposite to each other along a thickness direction of the silicone lens, the inner surface faces the device support and the at least one LED chip, and the inner surface is spaced apart from the at least one LED chip.

8. The light-emitting device of claim 1, wherein the silicone lens has a truncated-pyramid shape, the truncated-pyramid shape comprises an upper bottom surface, a lower bottom surface and a peripheral surface connecting the upper bottom surface and the lower bottom surface, the upper bottom surface and the lower bottom surface are arranged in parallel and opposite to each other, and the lower bottom surface is connected to the device support.

9. The light-emitting device according to claim 8, wherein the upper bottom surface is a circular plane or an elliptical plane, the peripheral surface is an arc-curved surface, and a light pattern of the silicone lens is circular or elliptical.

10. The light-emitting device according to claim 1, wherein the device support is at least partially conductive, and the at least one LED chip is conductively connected to a conductive part of the device support.

11. The light-emitting device according to claim 1, wherein the at least one LED chip comprises a Mini LED chip.

12. A display module, comprising:
a back plate; and
the light-emitting device according to any one of claims 1 to 11, and the light-emitting device is disposed on the back plate.

13. The display module according to claim 12, wherein the display module comprises a printed circuit board, the printed circuit board is disposed on the back plate, and a plurality of the light-emitting devices are arranged in an array on a side surface of the printed circuit board away from the back plate and spaced apart from each other.

14. The display module according to claim 12, wherein the display module further comprises a diffusion plate support, a diffusion plate, an optical film, a display panel, and a reflective sheet, the reflective sheet and the diffusion plate support are respectively disposed on a side surface of the back plate facing the display panel, the diffusion plate is disposed on a side surface of the diffusion plate support away from the reflective sheet, the optical film is disposed on a side of the diffusion plate away from the diffusion plate support, and the display panel is disposed on a side of the optical film away from the diffusion plate.

15. The display module according to claim 14, wherein the display panel is fixed on the back plate.
